# EUROPEAN PATENT SPECIFICATION

(11) **EP 1 088 371 B1**
(45) Date of publication and mention of the grant of the patent: **29.09.2004**
(21) Application number: 99927403.8
(22) Date of filing: 11.06.1999
(51) Int. Cl.: H01R 12/04, H01R 43/02, H05K 7/10

(54) **SOLDER BALL TERMINAL**
STIFT MIT LÖTKUGEL
BORNE A BILLE DE SOUDURE

(30) Priority: 15.06.1998 US 94957
(43) Date of publication of application: 04.04.2001
(73) Proprietor: ADVANCED INTERCONNECTIONS CORPORATION, West Warwick Rhode Island 02893 (US)
(72) Inventor: MURPHY, James, V., Warwick, RI 02886 (US)
(74) Representative: Charig, Raymond Julian
(86) International application number: PCT/US1999/013038
(87) International publication number: WO 1999/066599

(56) References cited:
- US-A- 5 410 807
- US-A- 5 479 319
- US-A- 5 593 322
- US-A- 5 669 774
- US-A- 5 742 481
- US-A- 5 777 852

## Description

### Background of the Invention

This invention relates to making connections between integrated circuit (IC) packages and circuit boards.

Ball grid array (BGA) packages are becoming increasingly popular because of their low profiles and high densities. The rounded solder ball contacts of a BGA are generally soldered directly to corresponding surface mount pads of a printed circuit board rather than to plated thru-holes which receive pins from, for example, a pin grid array IC package. However, once a BGA package is soldered to the printed circuit board, the soldered balls of the BGA package are difficult and expensive to inspect. Moreover, the packages are difficult to remove, for example, in situations where the IC package requires repairing or upgrading.

### Summary of the Invention

This invention relates to making a reliable low loss electrical interconnection between electrical contacts of individual substrates while duplicating the mating condition normally present between the solder ball of a ball grid array package (BGA) and an electrical contact area (e.g., surface mounted land) on one of the substrates. The term "substrate" is intended to mean any base member having electrical contact areas, including printed circuit boards, IC chip substrates or the packages supporting such chip substrates.

The electrical interconnection is provided with an intercoupling component (e.g., socket, adaptor or header assembly) including terminals which are positioned within an array of holes in an insulative support member and configured to electrically connect the array of connection regions of a substrate to an array of connection regions of another substrate. The array of holes in the support member are located in a pattern corresponding to the array of electrical connection regions of the substrate.

Soldering a BGA package to an intercoupling component is often preferable to soldering the package directly to a circuit board (e.g., motherboard). Using an intercoupling component facilitates removing the BGA package in situations where the package needs to be repaired or replaced. Moreover, because the intercoupling component generally has a lower mass than a motherboard, less heat is required to solder it to a BGA package; thus the BGA is subjected to less thermal stress.

US 5593322 describes a leadless high density connector comprising an insulating body having a ball grid array on a first surface thereof and an array of multiconductor pins extending from a second surface thereof. The solder balls of the ball grid array are respectively connected to discrete electrical conductors plated onto the outer cylindrical surface of the multiconductor pins which pins are themselves electrically insulating. The discrete electrical conductors on the pins are electrically connected to the respective solder balls by way of vias through the insulating body.

The present invention provides a method of providing an intercoupling component according to claims 1 and 11 and an intercoupling component according to claim 14.

In one application of the invention, an intercoupling component is in the form of a socket assembly which is soldered to a printed circuit board. The socket assembly receives another intercoupling component in the form of a pin adaptor assembly carrying a BGA package.

In one aspect of the invention, a method of providing such an intercoupling component includes positioning terminals within holes of an insulative support member and attaching a solder ball to each of the terminals. Attaching the solder ball to the terminals is accomplished using a fixture having a number of recesses located in a pattern corresponding to a pattern of the holes in the insulative support member; filling each of the recesses with a solder ball; positioning the insulative support member over the fixture so that an end of each of the terminals contacts a corresponding solder ball; soldering the solder ball to the end of the terminal while maintaining the generally spherical shape of the solder ball; and removing the insulative support member from the fixture. The solder balls are generally soldered by passing the insulative support member with terminals and solder balls through a reflow apparatus.

Each terminal element includes an elongated electrically conductive member having first and second ends, the first ends configured to be electrically connected to corresponding ones of the array of electrical connection regions disposed on the first substrate. The second ends of the terminals receive the solder balls.

Preferred embodiments of the above described inventions may include one or more of the following features for preventing the solder ball from melting around or along the side of the terminal when it is attached. For example, the holes may be sized to allow the second end of the terminals to be press-fit into the insulative support member so that only the surface of the second end of the terminals is exposed to the solder ball. The terminals may include solder resist coated around, but not on, the exposed surface of the second ends of the terminals. An insulative sheet member may be disposed over the lower surface of the support member and may include an array of holes sized to receive the second end of the terminals with a snug fit. The insulative sheet member may include a conductive circuit pattern (e.g., a ground plane or circuit traces).

Solder flux is provided to the second ends of the terminals. The terminals include, along their outer periphery, a pair of securing members. Upon being positioned within the insulative support member, a first one of the pair of securing members is positioned a length, relative to the upper surface of the support member, equal to about one-third the thickness of the insulative support member. Similarly, a second one of the pair securing members is positioned a length, relative to the opposite lower surface of the support member, equal to about one-third the thickness of the insulative support member.

In another aspect of the invention, the intercoupling component described above includes a pair of securing members disposed along the outer periphery of the terminal element. The terminal elements, upon being positioned within the insulative support member, include a first one of the pair securing members positioned a length, relative to the upper surface of the support member, equal to about one-third the thickness of the insulative support member. Similarly, a second one of the pair securing members is positioned a length, relative to the opposite lower surface of the support member, equal to about one-third the thickness of the insulative support member. In one embodiment, the first holes are sized to allow the second end of the terminal elements to be press-fit into the insulative support member so that substantially only the surface of the second end of the terminal elements are exposed. The intercoupling component also includes terminals having a solder ball, of the type normally used with BGA packages, preattached to at least one of the ends of the terminal. The solder ball electrically connects to an electrical connection region, such as a land of a substrate (e.g., printed circuit board). The other end of the terminal may also include a solder ball or may be adapted to electrically connect to a contact (e.g., pin terminal or socket terminal) of another substrate (e.g., pin adapter or socket).

The terminal with a preattached solder ball not only provides the desired mating condition of the solder ball to the circuit board, but is also solderable to a contact without having to apply additional solder paste or having to attach solder preforms to the ends of the socket terminals.

Other features and advantages of the invention will be apparent from the following description of the preferred embodiments and from the claims.

### Brief Description of the Drawing

Fig. 1 is an exploded, somewhat diagrammatic, isometric view of an intercoupling component assembly for a ball grid array package.
Fig. 2 is a side view of the intercoupling component of Fig. 1 having an adapter portion (in cross-section) and shown attached to a BGA package assembly.
Fig. 3 is a cross-sectional side view of a portion of a terminal support assembly, with a terminal shown partially in cross section.
Fig. 4 is a flowchart illustrating an approach for assembling the intercoupling component of Fig. 1.
Fig. 5 is a perspective view of a fixture for supporting the solder balls to be attached to the terminals.
Figs. 6A and 6B are cross-sectional side views of a portion of terminal support assembly and solder fixture prior to and after soldering, respectively.
Fig. 7 is a cross-sectional side view of a portion of an alternate embodiment of a terminal support assembly.
Fig. 8 is a cross-sectional side view of a portion of another embodiment of a terminal support assembly.
Fig. 9 is a cross-sectional side view of a portion of still another embodiment of a terminal support assembly.
Fig. 10 is a plan view of the portion of the terminal support assembly of Fig. 9.
Fig. 11 is a cross-sectional side view of a portion of still another embodiment of a terminal support assembly.
Fig. 12 is a side view of an alternate embodiment of an intercoupling component.
Fig. 13 is a cross-sectional side view of an alternate embodiment of the intercoupling component of Fig. 12.
Figs. 14A-14D illustrate one approach for assembling a terminal support assembly, such as that shown in Fig. 7.
Fig. 15 is a side view, partially in cross sectional, of an alternate embodiment of a terminal.

### Detailed Description

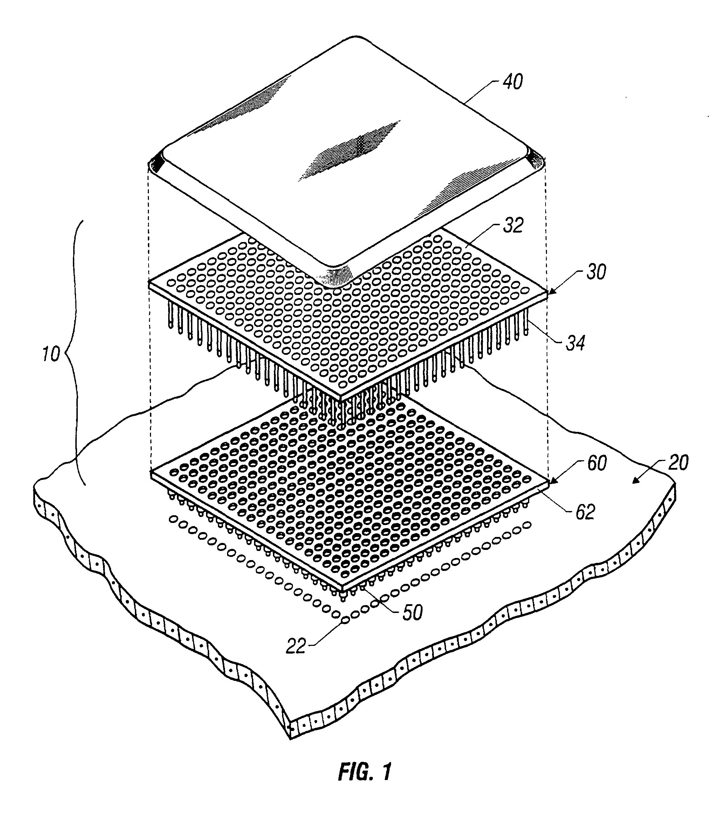

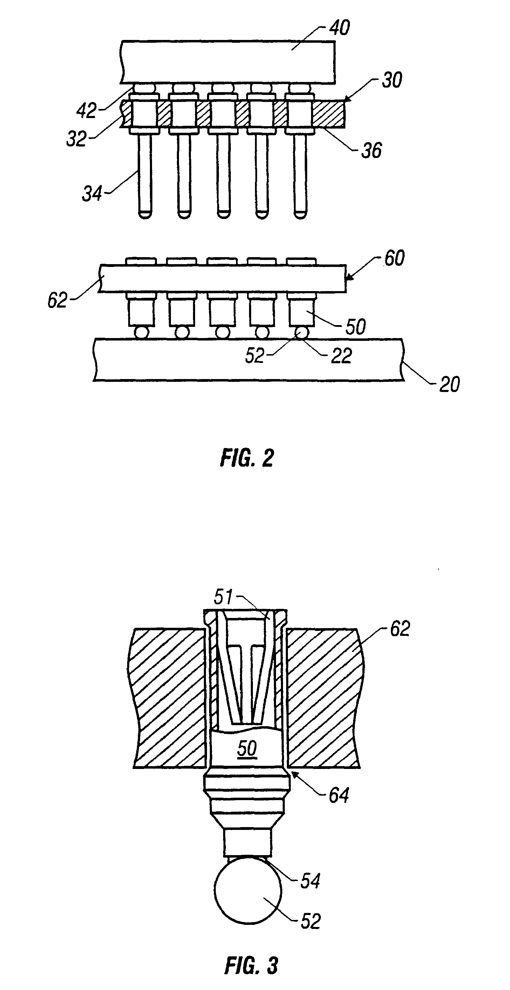

Referring to Figs. 1 and 2, an intercoupling component 10 is shown positioned to be connected to surface mount pads 22 of a printed circuit board 20. Adapter/socket assembly 10 includes a pin adapter 30 having an electrically insulative member 32 supporting pin terminals 34 positioned within an array of holes 36 in a pattern corresponding to a footprint of rounded solder balls 42 of a BGA package 40. When solder balls 42 of the BGA package are soldered to pin terminals 34 of pin adapter 30, the BGA package is converted to a high density pin grid array (PGA). Pin terminals 34 are received within socket terminals 50 of a socket 60. Socket 60 includes an insulative support member 62 for supporting the socket terminals positioned within an array of holes 64 (Fig. 3) in a pattern corresponding to the footprint of the surface mount pads 22.

Referring to Fig. 3, socket terminals 50 are of the type having spring contacts 51 which receive and electrically connect to pin terminals 34 of pin adapter 30. Each socket terminal includes a solder ball 52 preattached to its bottom end 54 to provide an identical mating condition to lands 22 as would have been the case had BGA package 40 been connected directly to the printed circuit board. In other applications, solder balls may be attached to pin terminals.

Holes 64 of insulative support member 62 have a diameter slightly larger than the diameter of the terminal supporting the solder ball 52 to allow the terminal to slightly move or "float" in the vertical direction. Thus, when the terminals with preattached solder balls are soldered to contacting areas of PC board 50, the floating terminals compensate for any lack of coplanarity between the contacting areas.

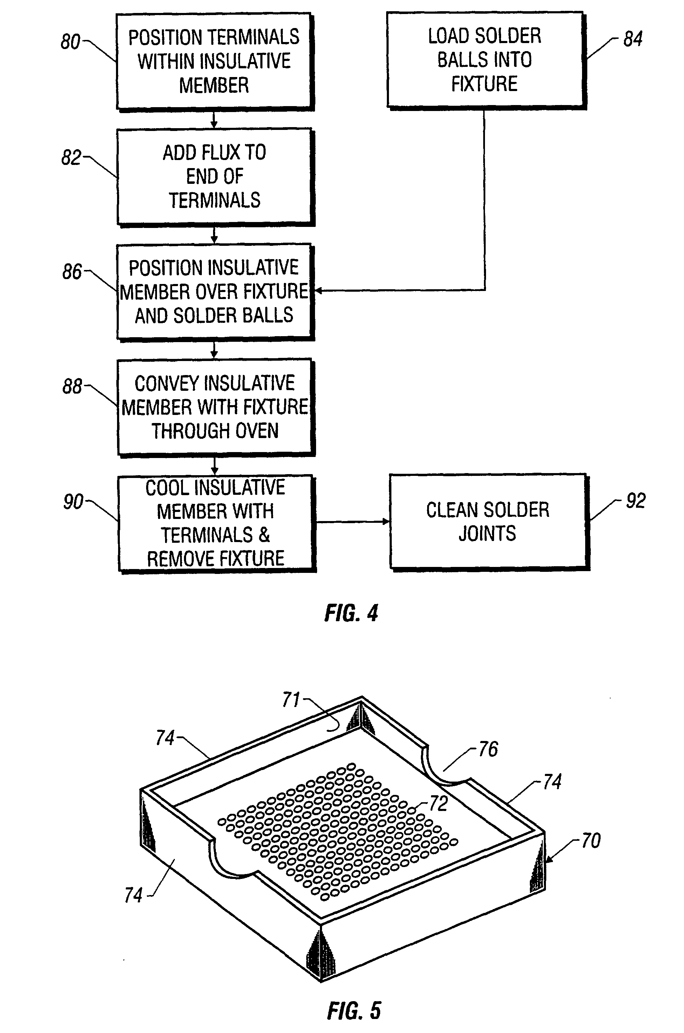

Referring to the flowchart of Fig. 4, a preferred approach for attaching a solder ball 52 to a terminal 50 of the type shown in Fig. 3 is shown. A vibration mechanism is generally used to initially position the individual terminals within holes 64. The terminals are then moved to a mechanism which seats the terminals so that they are fully positioned into holes 64 (step 80). Flux is then applied to the bottom ends of the individual terminals (step 82).

Referring to Fig. 5, an assembly fixture 70 formed of graphite and having rounded cavities 72, each of which receives a solder ball to be attached to the bottom end of a terminal. To fill each of the cavities with a solder ball, an indiscriminate number of the balls are poured into the fixture. The fixture is "jiggled" until each of the cavities accommodates a solder ball (step 84). Sidewalls 74 generally maintain the solder balls within the fixture and include cutouts 76 which allow excess solder balls to be emptied from the fixture when the fixture is tilted. The cavities are sized to allow the solder balls to extend slightly above the surface of fixture 70 where they contact the bottom end of the terminals.

Referring to Fig. 6A, with the cavities 72 filled with solder balls, the insulative support member 62 with terminals 50 is positioned within the assembly fixture 70 (step 86). Fixture 70 includes sidewalls 71 which are used to register the outer periphery of support member 62.

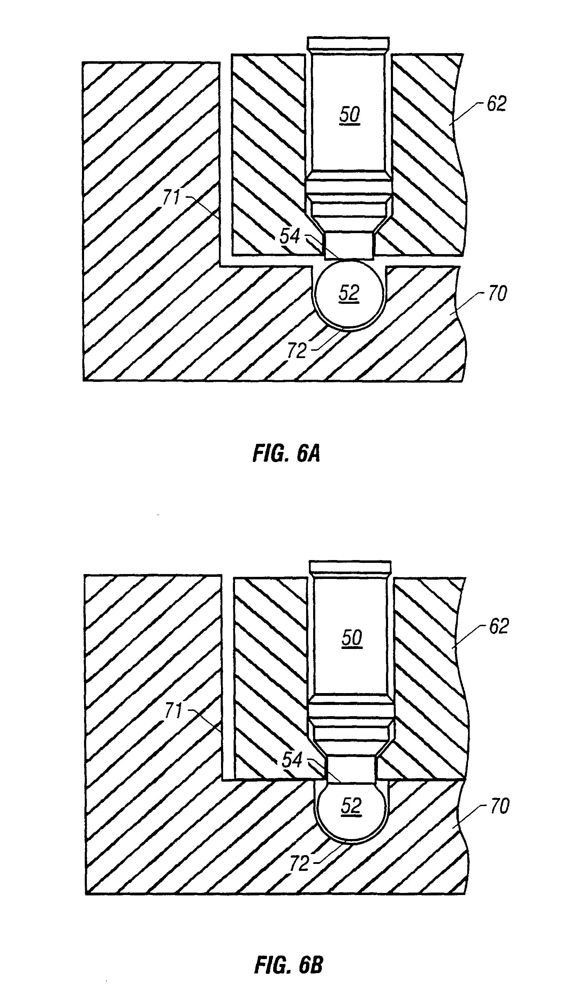

The insulative member and fixture are then passed through a reflow apparatus (e.g., infrared or convection oven) (step 88). The reflow apparatus is controlled to have a temperature profile which causes the solder ball to melt within cavities 72. Determining the temperature profile is largely an empirical process. The temperature profile used to solder the solder balls 52 to the ends of the terminals depends on a number of factors including: the style of terminal, the type of flux, plating conditions, the number and density of terminals placed in the insulative support member and the fixture design. The rounded shape of cavities 72 generally maintain the spherical shape of the solder balls when they melt. However, as shown in Fig. 6B, when the melt temperature of the solder balls is reached, the solder balls "slump" slightly around the terminal ends. Moreover, because the solder balls are positioned below the terminals, the solder balls do not slump or melt around the bottom ends of the terminals. Instead, attachment of the solder balls is limited to the bottom ends 54 of the terminals. When the solder ball has reflowed and is attached to its terminal the insulative member and fixture are removed from the oven and allowed to cool to room temperature (step 90). The fixture is detached from the now-assembled terminal support assembly and the solder joints between the balls and terminals are ultrasonically cleaned to remove excess flux (step 92).

In certain assembly procedures, the insulative member and terminals may be positioned below the assembly fixture which supports the solder balls. In this inverted position, the solder balls are positioned over the bottom end of the terminal instead of under the bottom end of the terminal as was the case in Figs. 6A and 6B. In these circumstances, it has been observed that if the flux is allowed to flow down and along the sides of the terminal, the reflowed solder ball may not maintain its round shape. Instead the ball melts and collapses around the bottom end of the terminal or disproportionately over one side of the terminal.

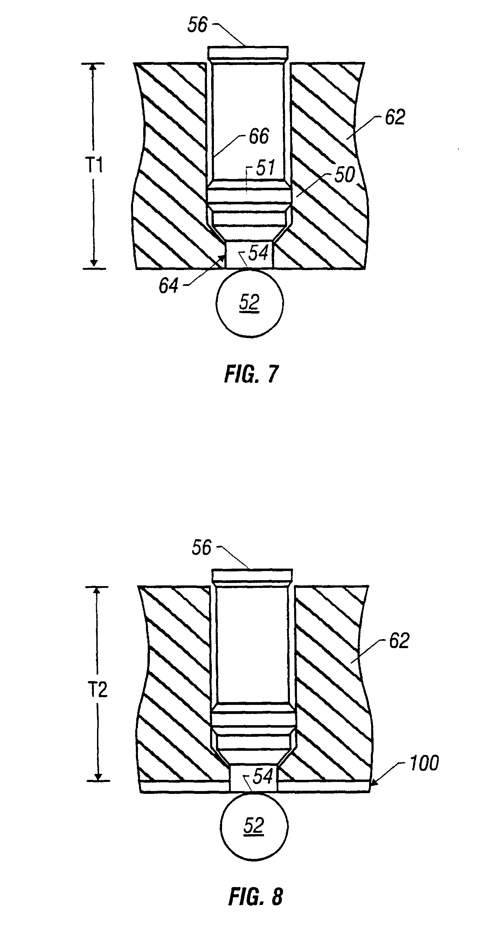

Referring to Fig. 7, in another embodiment, this problem is addressed by selecting the thickness (T1) of insulative support member 62 so that when the individual terminals are fully positioned within the holes of the insulative member, the top ends 56 of the terminals contact the top surface of the insulative member and the bottom ends 54 of the terminals extend only to the lower surface of the insulative member. Holes 64 are sized at the bottom surface of the insulative support member 62 to have a relatively snug fit between the bottom ends of the terminals and the holes. The close fit ensures that solder and/or flux does not flow along the outer side surfaces of the terminal element. Holes 64 include counterbores 66 with a diameter slightly larger than the diameter of ring 51 of the terminal and smaller than the head 56 of the terminal. The oversized counterbores facilitate loading the terminals within the insulative support member. In some embodiments, the bottom end of the terminal may include a counterbore sized to facilitate positioning of the solder ball to the terminal. With this configuration, the solder ball melts to fill the counterbore, thereby providing a generally more reliable mechanical connection to the terminal.

Referring to Fig. 8, in another embodiment for preventing flux and/or solder to flow along the sides of the terminals, a thin sheet of polyimide film 100 (e.g., 5-7 mils), is positioned over insulative support member 62. The polyimide film may be, for example, a Kapton® (a registered trademark of E.I. DuPont de Nemours & Co., Wilmington, DE) sheet. In this embodiment, the thickness (T2) of the insulative support member is selected so that when the individual terminals are fully positioned within the holes of the insulative member, the top ends 56 of the terminals contact the top surface of the insulative member and the bottom ends 54 of the terminals extend slightly beyond the lower surface of the support member a distance approximately that of the thickness of the film 100. The polyimide film includes an array of holes corresponding to the array of holes in the insulative member and is positioned over the lower surface of the insulative member 62. The polyimide film serves as a barrier to any flux which might otherwise flow along the sides of the terminal elements.

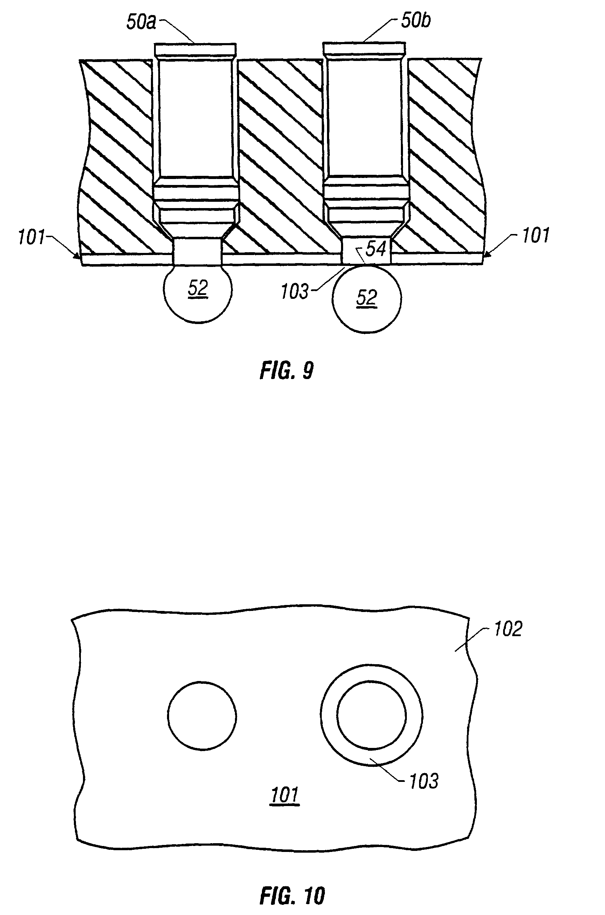

The polyimide film may also be used to support circuitry. For example, referring to Figs. 9 and 10, a polyimide film 100 has a conductive layer 101 which is etched to form a conductive circuit pattern 102 in the form of a ground plane. In this embodiment, a first terminal 50a is electrically connected to ground plane 102 while a second terminal 50b is isolated from the ground plane by etching away a circular ring 103 of the conductive layer. In other applications, the conductive circuit may be in the form of individual circuit traces.

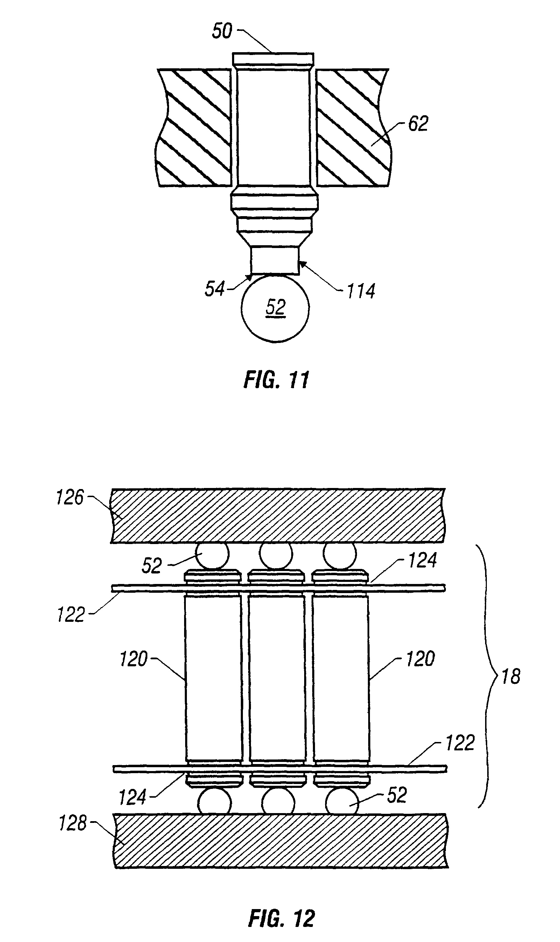

Referring to Fig. 11, in another embodiment, preconditioned flux is prevented from flowing to other areas of the terminal by applying solder resist 114 to the entire lower end of the terminal with the exception of the surface of the bottom end. The solder resist may be sprayed, dipped or applied as a paste to the lower end of the terminal with bottom end 54 masked.

Other embodiments are within the following claims. For example, referring to Fig. 12, an intercoupling component 118 includes terminals 120 configured to receive solder balls 52 at their top and bottom ends. The terminals are supported on a pair of thin sheets 122 which are approximately 0.127mm (0.005 inch) thick and are formed of a material such as Kapton™ which is flexible and electrically insulative. The ends of each terminal includes a V-shaped groove 124 which extends around the periphery of the terminal for engaging the edge of the polymeric film. Sheets 122 serve as a carrier for grouping, in a pre-selected spaced relationship, the terminals. Details in fabricating a carrier sheet which supports terminals is described in U.S. RE32,540, assigned to the assignee of the present invention. As shown in Fig. 12, the intercoupling component 118 serves as a header for connecting a pair of printed circuit boards 126 and 128.

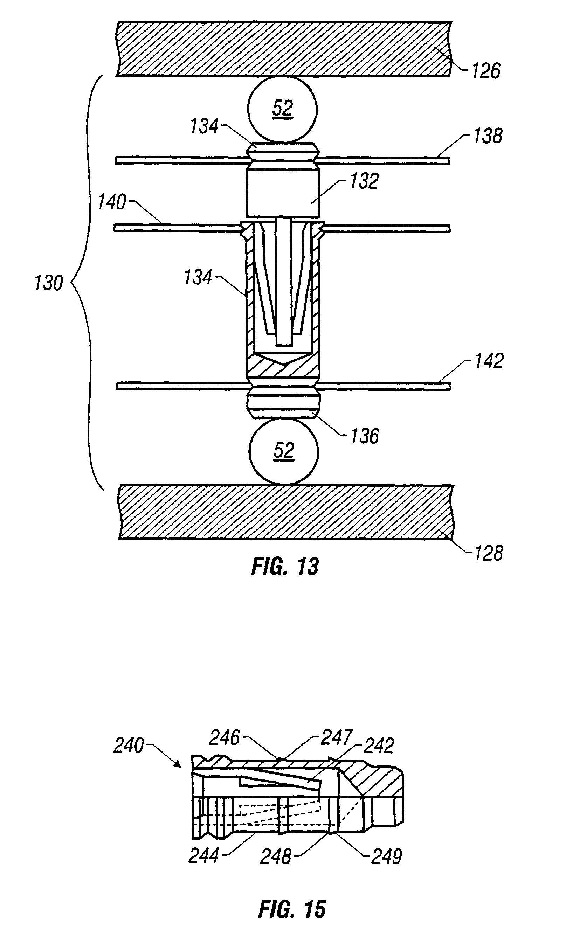

Referring to Fig. 13, an intercoupling component 130 similar to that shown in Fig. 12 can be provided in the form of a separable header. That is, the terminals positioned between circuit boards 126 and 128 include a terminal pin 132 having a solder ball preattached to its top end 134. Terminal pin 132 mates with a terminal socket 134 having a solder ball preattached to its bottom end 136. Terminal pin 132 is supported on a carrier sheet 138 while terminal socket 134 is supported at each of its ends on carrier sheets 140, 142.

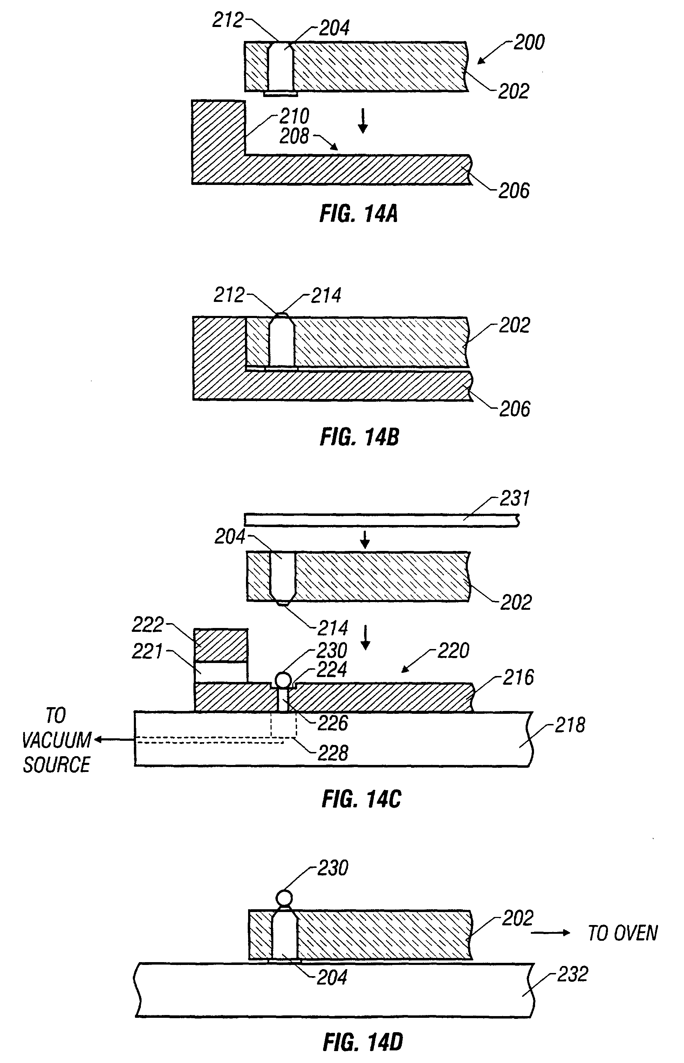

Referring to Figs. 14A-14D, an approach for assembling a terminal socket of the type described above is shown.

Referring to Fig. 14A, a socket assembly 200 includes an insulative support member 202 having terminal sockets 204 positioned within corresponding holes formed within the support member. Terminal sockets are positioned in support member 202 in the manner, for example, described in greater detail below in conjunction with Fig. 15. Although, for simplicity sake, only a single terminal socket 204 is shown in the figures, it is to be understood that support member 202 includes as many terminal sockets as the package requires. Support member 202 with terminal sockets 204 is positioned within a fixture 206 having a cavity 208 defined by sidewalls 210 and sized commensurate with the outer periphery of the support member.

Referring to Fig. 14B, exposed ends 212 of terminal sockets 204 are provided with a thin layer of solder flux 214 (not to scale in figure). Solder flux 214 may be provided using any of a variety techniques including screen printing techniques.

Referring to Fig. 14C, support member 202 is then removed from fixture 206 and placed within a ball positioning fixture 216 which, in turn, is positioned over a vacuum/shaker mechanism 218. Ball positioning fixture 216 includes an open cavity 220 defined by sidewalls 222 and sized commensurate with the outer periphery of the support member. Cavity 220 includes an array of recesses 224 corresponding to the array of terminal sockets 204, each recess having a vacuum channel 226 extending through fixture 216 and aligned with a vacuum port 228 of vacuum/shaker mechanism 218. Vacuum port 228 leads to a vacuum source (not shown).

In operation, solder balls 230 are loaded (e.g., poured) within fixture 216 and the vacuum/shaker mechanism is activated to cause the solder balls to be drawn into each of recesses 224 of cavity 220. An exit port 221 is provided within a sidewall of fixture 216 to allow excess solder balls to be removed from the fixture. When each of recesses 224 has a solder ball 230 positioned therein, shaking from the shaker/vacuum mechanism is discontinued. Vacuum is preferably maintained to ensure that solder balls 230 remain within recesses 224. Support member 202 is then placed within ball positioning fixture 216 so that ends 212 of terminal sockets 204 contact solder balls 230.

A cover plate 231 is positioned over support member 202 and vacuum is removed. Cover plate 231 and the support member 202 is then inverted or "flipped" (with or without ball positioning fixture 216). Cover plate 231 facilitates inverting support member 202 in a manner that prevents solder balls 230 from falling off ends 212. The viscosity of solder flux 214 allows contributes in maintaining the position of solder balls 230 on ends 212.

Referring to Fig. 14D, support member 202 and cover plate 231 are then passed through a reflow apparatus (e.g., infrared or convection oven), for example, by placing it on a conveyor belt 232 passing through the reflow apparatus. The reflow apparatus is controlled to have a temperature and speed profile which causes solder balls 230 to slightly slump over ends 212 while maintaining their generally spherical shape.

Referring to Fig. 15, a socket terminal 240 is shown which is particularly well-suited for being press-fit within support member 202 using the assembly procedure described above in conjunction with Figs. 14A-14D. Socket terminal 240 is similar to socket terminal 50 (Fig. 3) in that they both include a spring contact 242 for receiving and electrically connecting to a pin terminal of a pin adapter. Socket terminal 240 includes a shell portion 244 having a pair of barb-like rings 246, 248 extending around the periphery of the shell portion. Barb-like rings 246, 248 serve to secure the socket terminal within corresponding holes of the support member 202. Specifically, barb-like rings 246, 248 each have a tapered seating surface 247, 249 to facilitate insertion of the rings within support member 202 while impeding removal of the socket terminal within the support member once in place.

The relative positions of barb-like rings 246, 248 along the axial length of socket terminal is important. Specifically, ring 246 is positioned, from a first end of the socket terminal, a length (e.g., about 0,813 mm (0.032 inches)) approximately one-third the total thickness of the support member (e.g., 2,413 mm (0.095 inches)). Similarly, ring 248 is positioned, from an opposite end of the socket terminal, a length (e.g., about 0,813 mm (0.032 inches)) approximately one-third the total thickness of the support member. Positioning rings 246, 248 in this manner, minimizes bending or warping of support member 202 due to forces imparted by socket terminals when press-fit within the support member. The position of rings 246, 248 relative to the thickness of support member 202 allows the radial forces to be more evenly distributed to the support member. Although, barb-like rings 246, 248 extend entirely around the periphery of shell portion 244, in other embodiments, the rings may be in the form of arc-shaped segments. Further, although the use of barb-like rings 246, 248 has been described in conjunction with a socket terminal having a contact spring, use of the rings is equally applicable with other forms of terminals including pin terminals.

## Claims

1. A method of providing an intercoupling component (10) of the type used to couple an array of electrical connection regions (42) disposed on a first substrate (40) to an array of electrical connection regions (22) disposed on a second substrate (20), the method comprising the steps of:
providing an insulative support member (62) having holes (64) extending therethrough from an upper surface to an opposite lower surface, the holes located in a pattern corresponding to a pattern of the connection regions;
positioning a plurality of terminal elements (50) within the holes, each terminal element including an elongated electrically conductive member having first and second ends (56, 54), the first ends (56) configured to be electrically connected to corresponding ones of the array of electrical connection regions (42) disposed on the first substrate (40); and
attaching a solder ball (52) to each of the surfaces of the second ends (54) of the elongated electrically conductive members, each solder ball adapted to be reflowed to connect the terminal element (50) to the corresponding one of the array of connection regions (22) disposed on the second substrate (20),
the step of attaching the solder ball including:
providing a fixture (70) having a corresponding number of recesses (72) located in a pattern corresponding to a pattern of the holes in the insulative support member (62);
filling each of the recesses with a solder ball (52);
positioning the insulative support member (62) over the fixture (70) so that the second ends (54) of each of the terminals (50) contact a corresponding solder ball (52); and
soldering the solder ball to the second end of the terminal while maintaining the generally spherical shape of the solder ball.

2. The method of claim 1 further comprising isolating the surface of each of the second ends (54) of the elongated electrically conductive members (50).

3. The method of claim 2 wherein the isolating step comprises the step of positioning the terminal elements (50) within the holes (64) of the insulative support member (62) so that only surfaces at each of the second ends (54) are exposed.

4. The method of claim 2 wherein the isolating step comprises the step of applying a coating of solder resist (114) coated around the exposed surface of the second end (54).

5. The method of claim 2 wherein the isolating step comprises the steps of:
positioning an insulative sheet member (100) over a lower surface of the insulative support member (62), the insulative sheet member having an array of holes sized to receive the second ends (54) of the elongated electrically conductive members (50) in a close fit; and
positioning the terminal elements (50) within the insulative support member (62) so that only surfaces at each of the second ends (54) are exposed.

6. The method of claim 5 further comprising the step of providing a conductive circuit pattern (102) on the insulative sheet member (100).

7. The method of claim 1 further comprising:
providing solder flux to the second ends of each of the elongated, electrically conductive members (50).

8. The method of claim 7 further comprising inverting the insulative support member (62) prior to the soldering step and after the positioning the support member over the fixture (70).

9. The method of claim 1 wherein soldering the solder ball (52) includes passing the insulative support member (62) with terminal elements (50) and solder balls through a reflow apparatus.

10. The method of claim 1 wherein the terminal elements (50) include, along their outer periphery, a pair of securing members (246, 248), and upon being positioned within the insulative support member (62), a first one of the pair of securing members (246) is positioned a length, relative to the upper surface of the support member, equal to about one-third the thickness of the insulative support member, and a second one of the pair securing members (248) is positioned a length, relative to the opposite lower surface of the support member, equal to about one-third the thickness of the insulative support member.

11. A method of providing an intercoupling component (10) of the type used to couple an array of electrical connection regions (42) disposed on a first substrate (40) to an array of electrical connection regions (22) disposed on a second substrate (20), the method comprising the steps of:
providing an insulative support member (62) having holes (64) extending therethrough from an upper surface to an opposite lower surface, the holes located in a pattern corresponding to a pattern of the connection regions;
positioning a plurality of terminal elements (50) within the holes, each terminal element being an elongated electrically conductive member having first and second ends (56, 54), each elongated electrically conductive member (50) being sized to be press-fit within a corresponding one of the holes (64) of the insulative support member (62) so that the surface of each of the second ends (54) of the conductive members are isolated, the first ends (56) configured to be physically engaged with and electrically connected to corresponding ones of the array of electrical connection regions (42) disposed on the first substrate (40); and
attaching a solder ball (52) to each of the surfaces of the second ends (54) of the conductive members (50), each solder ball adapted to be reflowed to connect the terminal element to the corresponding one of the array of connection regions disposed on the second substrate.

12. The method of claim 11 wherein attaching a solder ball (52) to each of the surfaces of the second ends (54) of the conductive members (50) includes:
providing a fixture (70) having a corresponding number of recesses (72) located in a pattern corresponding to a pattern of the holes in the insulative support member (62);
filling each of the recesses (72) with a solder ball;
positioning the insulative support member (62) over the fixture so that the second ends (54) of each of the terminal elements (50) contacts a corresponding solder ball;
soldering the solder ball to the second end of the terminal while maintaining the generally spherical shape of the solder ball; and
removing the insulative support member from the fixture.

13. The method of claim 11 wherein soldering the solder ball (52) includes passing the insulative support member (62) with terminal elements (50) and solder balls through a reflow apparatus.

14. An intercoupling component (10) of the type used to couple an array of electrical connection regions (42) disposed on a first substrate (40) to an array of electrical connection regions (22) disposed on a second substrate (20), the intercoupling component comprising:
an insulative support member (62) having an upper surface and an opposite lower surface, the support member including an array of holes (64) extending transversely from the upper surface to the opposite lower surface, the array of holes located in a pattern corresponding to the array of the electrical connection regions (42) of the first substrate (40); and
a plurality of terminal elements (50), press-fit within the holes and configured to electrically connect the array of connection regions (42) of the first substrate (40) to the array of connection regions (22) of the second substrate (20), wherein each of the terminal elements comprises:
an electrically conductive member (50) having first and second ends (56, 54), the first end (56) adapted to be connected to a corresponding one of the array of electrical connection regions (42) disposed on the first substrate (40);
a solder ball (52) preattached to a surface of the second end (54) of the conductive member (50), the solder ball adapted to be reflowed to connect the terminal element to a corresponding one of the array of connection regions (22) disposed on the second substrate (20); and
a pair of securing members (246, 248) disposed along the outer periphery of the terminal element (240), a first one of the pair securing members (246) being positioned a length, relative to the upper surface of the support member (62), equal to about one-third the thickness of the insulative support member, and a second one of the pair securing members (248) being positioned a length, relative to the opposite lower surface of the support member (62), equal to about one-third the thickness of the insulative support member.

15. The intercoupling component of claim 14 wherein the holes (64) are sized to allow the second ends (54) of the terminal elements (50) to be press-fit into the insulative support member (62) so that substantially only the surfaces of the second ends (54) of the terminal elements are exposed.

## Patentansprüche

1. Verfahren zum Bereitstellen eines zwischenkoppelnden Bauteils (10), das verwendet wird, um ein Array von elektrischen Verbindungsregionen (42), die auf einem ersten Substrat (40) angeordnet sind, mit einem Array von elektrischen Verbindungsregionen (22), die auf einem zweiten Substrat (20) angeordnet sind, zu koppeln, wobei das Verfahren folgende Schritte umfasst:
Bereitstellen eines isolierenden Trägerelements (62) mit Löchern (64), die sich von einer oberen Oberfläche zu einer entgegengesetzten unteren Oberfläche erstrecken, wobei die Löcher in einem Muster angeordnet sind, das einem Muster der Verbindungsregionen entspricht;
Positionieren einer Mehrzahl von Anschlusselementen (50) innerhalb der Löcher, wobei jedes Anschlusselement ein längliches elektrisch leitendes Element mit ersten und zweiten Enden (56, 54) umfasst, wobei die ersten Enden (56) konfiguriert sind, um elektrisch mit der entsprechenden elektrischen Verbindungsregion des Arrays (42) verbunden zu sein, die auf dem ersten Substrat (40) angeordnet sind;
Befestigen einer Lötkugel (52) an jeder der Oberflächen der zweiten Enden (54) der länglichen elektrisch leitenden Elemente, wobei jede Lötkugel angepasst ist, um aufgeschmolzen zu werden, um das Anschlusselement (50) mit der entsprechenden Verbindungsregion (22) des Arrays zu verbinden, die auf dem zweiten Substrat (20) angeordnet sind,
wobei der Schritt des Befestigens der Lötkugel umfasst:
Bereitstellen einer Befestigungsvorrichtung (70) mit einer entsprechenden Anzahl von Ausnehmungen (72), die in einem Muster entsprechend einem Muster der Löcher in dem isolierenden Trägerelement (62) angeordnet sind;
Füllen jeder der Ausnehmungen mit einer Lötkugel (52);
Positionieren des isolierenden Trägerelements (62) über der Befestigungsvorrichtung (70), sodass die zweiten Enden (54) jedes Anschlusses (50) eine entsprechende Lötkugel (52) kontaktieren; und
Löten der Lötkugel an das zweite Ende des Anschlusses, während die im allgemeinen sphärische Form der Lötkugel beibehalten wird.

2. Verfahren gemäß Anspruch 1, ferner mit einem IsoIieren der Oberfläche jedes zweiten Endes (54) der länglichen elektrisch leitenden Elementen (50).

3. Verfahren gemäß Anspruch 2, bei dem der Isolierschritt den Schritt eines Positionierens der Anschlusselemente (50) innerhalb der Löcher (64) des isolierenden Trägerelementes (62) umfasst, sodass nur Oberflächen an jedem der zweiten Enden (54) freiliegen.

4. Verfahren gemäß Anspruch 2, bei dem der Isolierschritt den Schritt eines Aufbringens einer Beschichtung von Lötmittelresist (114) umfasst, das um die freigelegte Oberfläche der zweiten Enden (54) geschichtet ist.

5. Verfahren gemäß Anspruch 2, bei dem der Isolierschritt folgende Schritte umfasst:
Positionieren eines isolierenden Blattelements (100) über einer unteren Oberfläche des isolierenden Trägerelements (62), wobei das isolierende Blattelement ein Array von Löchern aufweist, die dimensioniert sind, um die zweiten Enden (54) der iänglichen elektrisch leitenden Elementen (50) in einer strammen Passung aufzunehmen;
Positionieren der Anschlusselemente (50) innerhalb des isolierenden Trägerelements (62), sodass nur Oberflächen an jedem zweiten Ende (54) freigelegt sind.

6. Verfahren gemäß Anspruch 5, ferner mit dem Schritt des Bereitstellens eines leitenden Schaltungsmusters (102) auf dem isolierenden Blattelement (100).

7. Verfahren gemäß Anspruch 1, ferner mit:
Bereitstellen von Lötmittelfluss an den zweiten Enden jeder der länglichen elektrisch leitenden Elemente (50).

8. Verfahren gemäß Anspruch 7, ferner mit einem Invertieren des isolierenden Trägerelements (62) vor dem Lötschritt und nach dem Positionieren des Trägerelements über der Befestigungsvorrichtung (70).

9. Verfahren gemäß Anspruch 1, bei dem das Löten der Lötkugel (52) einen Durchlauf des isolierenden Trägerelements (62) mit Anschlusselementen (50) und Lötkugeln durch eine Aufschmelzvorrichtung umfasst.

10. Verfahren gemäß Anspruch 1, bei dem die Anschlusselemente (50) entlang ihres äußeren Umfangs ein Paar von Sicherungselementen (246, 248) umfassen, und beim Positionieren innerhalb des isolierenden Trägerelements (62) ein erstes Paar von Sicherungselementen (246) um eine Länge relativ zu der oberen Oberfläche der Trägerelemente positioniert wird, die gleich etwa einem Drittel der Dicke des isolierenden Trägerelements ist, und ein zweites Paar von Sicherungselementen (248) um eine Länge relativ zu der oberen unteren Oberfläche des Trägerelements positioniert wird, die gleich etwa einem Drittel der Dicke des isolierenden Trägerelements ist.

11. Verfahren zum Bereitstellen eines zwischenkoppelnden Bauteils (10), das verwendet wird, um ein Array von elektrischen Verbindungsregionen (42), die auf einem ersten Substrat (40) angeordnet sind, mit einem Array von elektrischen Verbindungsregionen (22), die auf einem zweiten Substrat (20) angeordnet sind, zu koppeln, wobei das Verfahren folgende Schritte umfasst:
Bereitstellen eines isolierenden Trägerelements (62) mit Löchern (64), die sich von einer oberen Oberfläche zu einer entgegengesetzten unteren Oberfläche erstrecken, wobei die Löcher in einem Muster angeordnet sind, das einem Muster der Verbindungsregionen entsprecht;
Positionieren einer Mehrzahl von Anschlusselementen (50) innerhalb der Löcher, wobei jedes Anschlusselement ein längliches elektrisch leitendes Element mit ersten und zweiten Enden (56, 54) ist, wobei jedes längliche elektrisch leitende Element (50) dimensioniert ist, um eine stramme Passung innerhalb eines entsprechenden Lochs (64) des isolierenden Trägerelementes (62) aufzuweisen, sodass die Oberfläche jedes zweiten Endes (54) der leitenden Elemente isoliert ist, wobei die ersten Enden (56) konfiguriert sind, um physisch mit entsprechenden elektrischen Verbindungsregionen (42) des Arrays in Eingriff genommen zu werden und elektrisch mit diesen verbunden zu sein, die auf dem ersten Substrat (40) angeordnet sind;
Befestigen einer Lötkugel (52) an jeder Oberfläche der zweiten Enden (54) der leitenden Elemente (50), wobei jede Lötkugel angepasst ist, um aufgeschmolzen zu werden, um das Anschlusselement mit der entsprechenden Verbindungsregion des Arrays zu verbinden, die auf dem zweiten Substrat angeordnet sind.

12. Verfahren gemäß Anspruch 11, bei dem das Befestigen einer Lötkugel (52) an jeder der Oberflächen der zweiten Enden (54) der leitenden Elemente (50) umfasst:
Bereitstellen einer Befestigungsvorrichtung (70) mit einer entsprechenden Anzahl von Ausnehmungen (72), die in einem Muster entsprechend einem Muster der Löcher in dem isolierenden Trägerelemente (62) angeordnet sind;
Füllen jeder Ausnehmung (72) mit einer Lötkugel;
Positionieren des isolierenden Trägerelements (62) über der Befestigungsvorrichtung, sodass die zweiten Enden (54) jedes Anschlusselements (50) eine entsprechende Lötkugel kontaktieren;
Löten der Lötkugel an das zweite Ende des Anschlusses, während die im allgemeinen sphärische Form der Kugel beibehalten wird;
Entfernen des isolierenden Trägerelements von der Befestigungsvorrichtung.

13. Verfahren gemäß Anspruch 13, bei dem das Löten der Lötkugel (52) einen Durchlauf des isolierenden Trägerelements (62) mit Anschlusselementen (50) und Lötkugeln durch eine Aufschmelzvorrichtung umfasst.

14. Zwischenkoppelndes Bauteil (10), um ein Array von elektrischen Verbindungsregionen (42), die auf einem ersten Substrat (40) angeordnet sind, mit einem Array von elektrischen Verbindungsregionen (22), die auf einem zweiten Substrat (20) angeordnet sind, zu koppeln, wobei das zwischenkoppelnde Bauteil umfasst:
ein isolierendes Trägerelement (62) mit einer oberen Oberfläche und einer gegenüberliegenden unteren Oberfläche aufweist, wobei das.Trägerelement ein Array von Löchern (64) umfasst, die sich quer von der oberen Oberfläche zu der entgegengesetzten unteren Oberfläche erstrecken, wobei das Array in einem Muster entsprechend dem Array der elektrischen Verbindungsregionen (42) des ersten Substrats (40) angeordnet ist, und
eine Mehrzahl von Anschlusselementen (15), die eine stramme Passung innerhalb der Löcher aufweisen und konfiguriert sind, um das Array von Verbindungsregionen des ersten Substrats (40) mit dem Array von Verbindungsregionen (22) des zweiten Substrats (20) zu verbinden, wobei jedes der Anschlusselemente umfasst:
ein elektrisch leitendes Element (50) mit ersten und zweiten Enden (56, 54), wobei das erste Ende (56) angepasst ist, um mit einer entsprechenden elektrischen Verbindungsregion (42) des Arrays verbunden zu sein, die auf dem ersten Substrat (40) angeordnet sind;
eine Lötkugel (52), die an einer Oberfläche des zweiten Endes (54) des leitenden Elements (50) vorbefestigt ist, wobei die Lötkugel angepasst ist, um aufgeschmolzen zu werden, um das Anschlusselement mit einer entsprechenden Verbindungsregion (22) des Arrays zu verbinden, die auf dem zweiten Substrat (20) angeordnet sind;
und ein Paar von Sicherungselementen (246, 248), die entlang des äußeren Umfangs des Anschlusselements (240) angeordnet sind, wobei ein erstes Paar von Sicherungselementen (246) um eine Länge relativ zu der oberen Oberfläche des Trägerelements (62) positioniert ist, die etwa gleich einem Drittel der Dicke des isolierenden Trägerelements ist, und ein zweites Paar von Sicherungselementen (248) um eine Länge relativ zu der gegenüberliegenden unteren Oberfläche des Trägerelements (62) positioniert ist, die etwa gleich einem Drittel der Dicke des isolierenden Trägerelements ist.

15. Zwischenkoppelndes Bauteil gemäß Anspruch 14, bei dem die Löcher (64) positioniert sind, um zu ermöglichen, dass die zweiten Enden (54) der Anschlusselemente (50), eine stramme Passung in dem isolierenden Trägerelement (62) aufweisen, sodass im wesentlichen nur die Oberflächen der zweiten Enden (54) der Anschlusselemente freiliegen.

## Revendications

1. Procédé de réalisation d'un composant d'interconnexion (10) du type utilisé pour coupler un réseau de régions de connexion électrique (42) disposées sur un premier substrat (40) à un réseau de régions de connexion électrique (22) disposées sur un second substrat (20), le procédé comprenant les étapes consistant à :
réaliser un élément formant support isolant (62) ayant des trous (64) le traversant depuis une surface supérieure à une surface inférieure opposée, les trous étant répartis selon un motif correspondant à un motif des régions de connexion ;
positionner une pluralité d'éléments formant borne (50) à l'intérieur des trous, chaque élément formant borne comprenant un élément allongé électriquement conducteur ayant une première et une seconde extrémités (56, 54), les premières extrémités (56) étant configurées pour être électriquement connectées aux régions correspondantes du réseau de régions de connexion électrique (42) disposées sur le premier substrat (40) ; et
fixer une bille de soudure (52) à chacune des surfaces des secondes extrémités (54) des éléments allongés électriquement conducteurs, chaque bille de soudure étant adaptée pour subir une refusion pour connecter l'élément formant borne (50) à la région correspondante du réseau de régions de connexion (22) disposées sur le second substrat (20),
l'étape consistant à fixer la bille de soudure comprenant les étapes consistant à :
proposer un dispositif de fixation (70) ayant un nombre correspondant d'évidements (72) situés dans un motif correspondant à un motif des trous dans l'élément formant support isolant (62) ;
remplir chacun des évidements avec une bille de soudure (52) ;
positionner l'élément formant support isolant (62) sur le dispositif de fixation (70) de sorte que les secondes extrémités (54) de chacune des bornes (50) entrent en contact avec une bille de soudure correspondante (52) ; et
souder la bille de soudure à la seconde extrémité de la borne tout en maintenant la forme généralement sphérique de la bille de soudure.

2. Procédé selon la revendication 1, comprenant en outre d'isoler la surface de chacune des secondes extrémités (54) des éléments allongés électriquement conducteurs (50).

3. Procédé selon la revendication 2, dans lequel l'étape d'isolation comprend l'étape consistant à positionner les éléments formant bornes (50) à l'intérieur des trous (64) de l'élément formant support isolant (62) de manière à ce que seules les surfaces au niveau de chacune des secondes extrémités (54) soient exposées.

4. Procédé selon la revendication 2, dans lequel l'étape d'isolation comprend l'étape consistant à appliquer un revêtement de réserve de soudage (114) revêtu autour de la surface exposée de la seconde extrémité (54).

5. Procédé selon la revendication 2, dans lequel l'étape d'isolation comprend les étapes consistant à :
positionner un élément formant feuille isolante (100) sur une surface inférieure de l'élément formant support isolant (62), l'élément formant feuille isolante ayant un réseau de trous dimensionnés pour recevoir les secondes extrémités (54) des éléments allongés électriquement conducteurs de manière parfaitement ajustée ; et
positionner les éléments formant bornes (50) dans l'élément formant support isolant (62) de manière à ce que seules les surfaces au niveau de chacune des secondes extrémités (54) soient exposées.

6. Procédé selon la revendication 5 comprenant en outre l'étape consistant à réaliser un tracé de circuit conducteur (102) sur l'élément formant feuille isolante (100).

7. Procédé selon la revendication 1, comprenant en outre l'étape consistant à :
appliquer un flux de brasage aux secondes extrémités (54) de chacun des éléments allongés électriquement conducteurs (50).

8. Procédé selon la revendication 7 comprenant en outre d'inverser l'élément formant support isolant (62) avant l'étape de brasage et après le positionnement de l'élément formant support sur le dispositif de fixation (70).

9. Procédé selon la revendication 1, dans lequel le brasage de la bille de soudure (52) comprend de faire passer l'élément formant support isolant (62) avec les éléments formant bornes (50) et les billes de soudure à travers un appareil de refusion.

10. Procédé selon la revendication 1, dans lequel les éléments formant bornes (50) comprennent, le long de leur périphérie externe, une paire d'éléments de fixation (246, 248), et lorsqu'ils sont positionnés dans l'élément formant support isolant (62), un premier élément de la paire d'éléments de fixation (246) est positionné à une longueur, par rapport à la surface supérieure de l'élément formant support, égale à environ un tiers de l'épaisseur de l'élément formant support isolant, et un second élément de la paire d'éléments de fixation (248) est positionné à une longueur, par rapport à la surface inférieure opposée de l'élément formant support, égale à environ un tiers de l'épaisseur de l'élément formant support isolant.

11. Procédé de réalisation d'un composant d'interconnexion (10) du type utilisé pour coupler un réseau de régions de connexion électrique (42) disposées sur un premier substrat (40) à un réseau de régions de connexion électrique (22) disposées sur un second substrat (20), le procédé comprenant les étapes consistant à :
réaliser un élément formant support isolant (62) ayant des trous (64) le traversant depuis une surface supérieure à une surface inférieure opposée, les trous étant disposés selon un motif correspondant à un motif des régions de connexion ;
positionner une pluralité d'éléments formant bornes (50) à l'intérieur des trous, chaque élément formant borne étant un élément allongé électriquement conducteur ayant des premières et des secondes extrémités (56, 54), chaque élément allongé électriquement conducteur (50) étant dimensionné pour être ajusté par pression à l'intérieur d'un trou correspondant des trous (64) de l'élément formant support isolant (62) de telle manière que la surface de chacune des secondes extrémités (54) des éléments conducteurs soit isolée, les premières extrémités (56) étant configurées pour être physiquement engagées et électriquement connectées aux régions correspondantes du réseau de régions de connexion électrique (42) disposées sur le premier substrat (40) ; et
fixer une bille de soudure (52) à chacune des surfaces des secondes extrémités (54) des éléments conducteurs (50), chaque bille de soudure étant adaptée pour subir une refusion pour connecter l'élément formant borne à la région correspondante du réseau de régions de connexion disposées sur le second substrat.

12. Procédé selon la revendication 11, dans lequel l'étape consistant à fixer une bille de soudure (52) au niveau de chacune des surfaces des secondes extrémités (54) des éléments conducteurs (50) comprend les étapes consistant à :
réaliser un dispositif de fixation (70) ayant un nombre correspondant d'évidements (72) disposés selon un motif correspondant à un motif des trous dans l'élément formant support isolant (62) ;
remplir chacun des évidements (72) avec une bille de soudure ;
positionner l'élément formant support isolant (62) sur le dispositif de fixation de sorte que les secondes extrémités (54) de chacune des bornes (50) entrent en contact avec une bille de soudure correspondante ;
souder la bille de soudure à la seconde extrémité de la borne tout en maintenant la forme généralement sphérique de la bille de soudure ; et
retirer l'élément formant support isolant du dispositif de fixation.

13. Procédé selon la revendication 11, dans lequel le brasage de la bille de soudure (52) comprend de faire passer l'élément formant support isolant (62) avec les éléments formant bornes (50) et les billes de soudure à travers un appareil de refusion.

14. Composant d'interconnexion (10) du type utilisé pour coupler un réseau de régions de connexion électrique (42) disposées sur un premier substrat (40) à un réseau de régions de connexion électrique (22) disposées sur un second substrat (20), le composant d'interconnexion comprenant :
un élément formant support isolant (62) ayant une surface supérieure et une surface inférieure opposée, l'élément formant support comprenant un réseau de trous (64) s'étendant transversalement depuis la surface supérieure à la surface inférieure opposée, le réseau de trous étant situé selon un motif correspondant au motif des régions de connexion électrique (42) du premier substrat (40) ; et
une pluralité d'éléments formant bornes (50) ajustés par pression dans les trous et configurés pour connecter électriquement le réseau de régions de connexion (42) du premier substrat (40) au réseau de régions de connexion (22) du second substrat (20), dans lesquels chacun des éléments formant bornes comprend :
un élément électriquement conducteur (50) ayant une première et une seconde extrémités (56, 54), la première extrémité (56) étant adaptée pour être connectée à une région correspondante du réseau de régions de connexion électrique (42) disposées sur le premier substrat (40) ;
une bille de soudure (52) préfixée au niveau de la surface de la seconde extrémité (54) de l'élément conducteur (50), la bille de soudure étant adaptée pour subir une refusion pour connecter l'élément formant borne à une région correspondante du réseau de régions de connexion (22) disposées sur le second substrat (20) ; et
une paire d'éléments de fixation (246, 248) disposés le long de la périphérie externe de l'élément formant borne (240), un premier élément de la paire d'éléments de fixation (246) étant positionné à une longueur, par rapport à la surface supérieure de l'élément formant support (62), égale à environ un tiers de l'épaisseur de l'élément formant support isolant, et un second élément de la paire d'éléments de fixation (248) étant positionné à une longueur, par rapport à la surface inférieure opposée de l'élément formant support (62), égale à environ un tiers de l'épaisseur de l'élément formant support isolant.

15. Composant d'interconnexion selon la revendication 14, dans lequel les trous (64) sont dimensionnés pour permettre aux secondes extrémités (54) des éléments formant bornes (50) d'être ajustées par pression dans l'élément formant support isolant (62) de manière à ce que sensiblement seules les surfaces des secondes extrémités (54) des éléments formant bornes soient exposées.
